# EUROPEAN PATENT SPECIFICATION

(11) **EP 2 485 241 B1**
(45) Date of publication and mention of the grant of the patent: **04.12.2019**
(21) Application number: 12153682.5
(22) Date of filing: 02.02.2012
(51) Int. Cl.: H01J 37/34, H01J 37/32, C23C 14/32

(54) **Post cathode physical vapor deposition system and magnet array for use within a post cathode**
Physikalisches Dampfabscheidungssystem mit einer Rohrkathode und Magnetanordnung zur Anwendung in einer Rohrkathode
Système de dépôt physique en phase vapeur à cathode tubulaire et réseau d'aimants destiné à être utilisé dans une cathode tubulaire

(30) Priority: 02.02.2011 US 201113019326
(43) Date of publication of application: 08.08.2012
(73) Proprietor: United Technologies Corporation, Farmington, CT 06032 (US)
(72) Inventor: Tryon, Brian S., Glastonbury, CT Connecticut 06033 (US); Beers, Russell A., Manchester, CT Connecticut 06040 (US)
(74) Representative: Dehns

(56) References cited:
- EP-A1- 0 284 145
- GB-A- 2 410 255
- US-A- 4 221 652
- US-A- 5 953 827
- US-A- 5 972 185
- US-A1- 2008 138 529
- "Information about holding magnets" In: IBS Magnet: "Magnetism: permanent magnets, materials and magnet systems", 17 September 2007 (2007-09-17), Cologne, XP002677494, pages 1-41, * page 19 *

## Description

### BACKGROUND

The present disclosure is related to a post cathode physical vapor deposition (PVD) system, and in particular, to a magnet array for use within a post cathode.

Cathodic arc is one type physical vapor deposition (PVD) system which is utilized to form coatings by vaporizing a material and depositing that material on a piece, thereby coating the piece with a thin layer of the material. Cathodic arc systems use a cathode/anode arrangement where the cathode includes an evaporation surface made from the coating material. The cathode and the anode of the PVD system are contained within a vacuum chamber. A power source is connected to the cathode and the anode with the positive connection of the power source connected to the anode and the negative connection of the power source connected to the cathode. By connecting the positive power connection to the anode and the negative power connection to the cathode, a charge disparity between the anode and the cathode is generated. The charge disparity causes an electrical arc to jump between the cathode and the anode. In standard PVD systems, the arc location is random over the surface of the cathode. The arcing causes the surface of the cathode to vaporize at the point where the arc occurred. The vaporized cathode material then coats the piece contained in the vacuum chamber.

In order to control the density and distribution of the coating, steered arc systems control the location of the arc on the cathode's surface by manipulating magnetic fields within and around the cathode. This also aids in the regular/even wearing of the cathode/source material, thus, helping to allow for the most useful consumption of the cathode/source material during the coating deposition process. US5972185 discloses a cathodic arc PVD device, which comprises an annular cathode with an evaporative surface and an apparatus for steering the arc around the evaporative surface, said apparatus producing a magnetic field that runs substantially parallel to said surface.

GB-A-2410255 discloses a cathode arc discharge evaporating device of the prior art. Information about holding magnets is disclosed in IBS Magnet: "Magnetism: permanent magnets, materials and magnet systems", 17 September 2007, Cologne, XP002677494, pages 1-41. EP-A1-0284145 discloses a post cathode arc discharge evaporating device having a magnetic field generating device, which is moveable with respect to the cathode and which comprises an assembly of permanent magnets between which soft iron parts are provided. US5953827 discloses a rotating magnetron disposed on the non-process environment side of a target, and comprising a magnet assembly between a bottom plate and a top plate.

### SUMMARY

In accordance with a first aspect of the present invention, there is provided a post cathode physical vapor deposition system as set forth in claim 1.

Also in accordance with a second aspect of the present invention there is provided a magnet array as set forth in claim 2.

### BRIEF DESCRIPTION OF THE DRAWINGS

The disclosure can be further understood by reference to the following detailed description when considered in connection with the accompanying drawings wherein:
Figure 1 schematically illustrates an example PVD system having a post cathode.
Figure 2 illustrates an example post cathode for use in the PVD system of Figure 1.
Figure 3 illustrates an example magnet array for use in the post cathode of Figure 2.
Figure 4 illustrates a top view of the example array of Figure 3.

### DETAILED DESCRIPTION

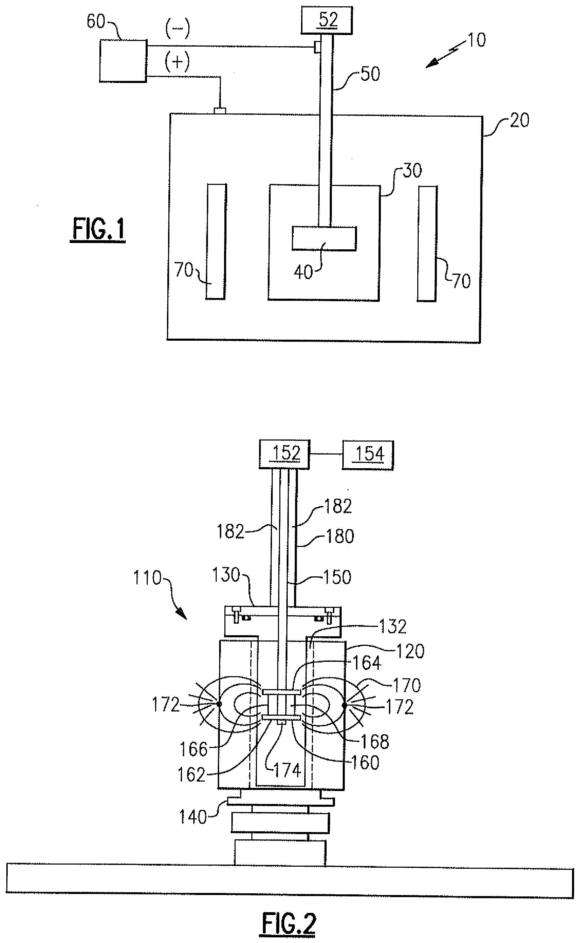

Figure 1 illustrates an example physical vapor deposition (PVD) system 10 using a post cathode 30. The post cathode 30 is located within a vacuum chamber 20. One or more parts 70 are placed within the vacuum chamber 20 adjacent to the post cathode 30. An inner surface of the vacuum chamber 20 doubles as an anode for the PVD system 10. Alternately, an independent anode may be used within the vacuum chamber 20. A magnetic array 40 is suspended within a hollow center of the post cathode 30 via a shaft 50. The shaft 50 can be actuated with a linear actuator 52, thereby moving the magnet array 40 linearly along an axis defined by the shaft 50. Alternate methods of axially moving the magnet 40 can be used, with minor modifications to the disclosed system.

When power is supplied from a power source 60 to the PVD system 10, the cathode 30 arcs at or near a point on its surface having the strongest intersection with a magnetic field produced by the magnet array 40. Moving the magnet array 40 adjusts the location of the magnetic field, and thus the location of the arc. Control over the location of the cathodic arc provides a degree of control over the coating density distribution by controlling where the coating vapor originates. It is understood in the art that sections of a part 70 closer to a point of vapor origination will receive a denser coating than sections of the part 70 that are farther away from the point of vapor origination.

Figure 2 illustrates a detailed schematic drawing of the post cathode 30 and the shaft 50 of Figure 1, with a shaft 150 corresponding to the shaft 50 of Figure 1. The shaft 150 extends through a top cathode cap 130 into a hollow center 132 of the cylindrical post cathode 110. The shaft 150 is connected to a magnet array 160. The magnet array 160 is a plurality of post magnets 166, 168 sandwiched together by a top pole plate 164 and a bottom pole plate 162. The magnetic field 170 of the magnet array 160 intersects a side wall of the post cathode 110 at an intersection point 172, thereby causing the arc to occur at or near the intersection point 172. The side wall is a cylinder 120 constructed of an evaporation source material, and is electrically connected to the top cathode cap 130 and the bottom cathode cap 140. As known in the art, the evaporation source material is fabricated from nominally the same material as the desired coating composition.

The shaft 150 extends out of the post cathode 110, and is connected to an actuator 152. The actuator moves the shaft 150 along an axis defined by the shaft 150. Movement of the magnet array 160 attached to the shaft 150 causes a corresponding movement of the intersection point 172. The shaft 150 in the illustrated example is encompassed within a cooling shaft 180. The cooling shaft 180 includes fluid passageways 182 that provide a cooling fluid flow to the post cathode 110. Actuation of the shaft 150 and movement of the magnet array 160 can be controlled using a controller 154 according to known principles.

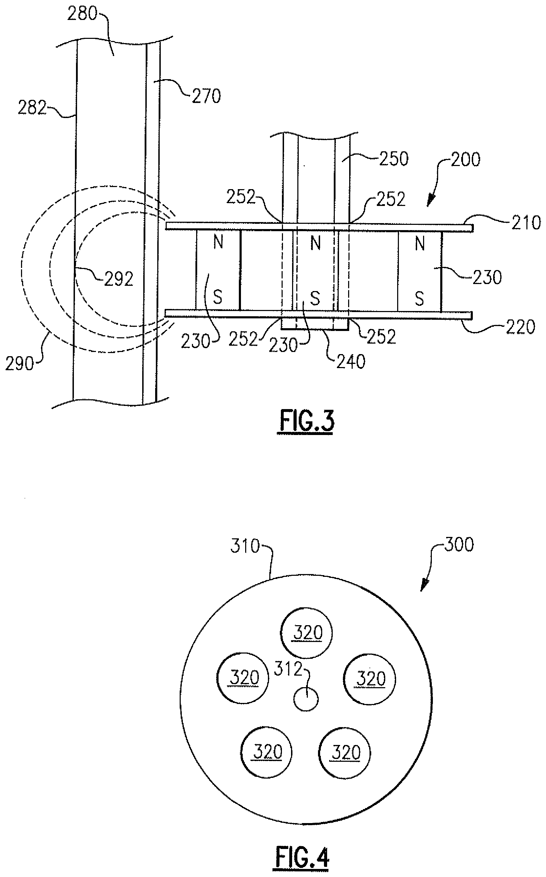

A detailed example magnet array 200 for use in the post cathode 110 of Figure 2 is illustrated in Figure 3. The magnet array 200 has multiple individual post magnets 230 sandwiched between a top pole plate 210 and a bottom pole plate 220. The shaft 250 extends through a center hole 252 in each of the pole plates 210, 220, and is attached to the pole plates 210, 220 via an attachment feature 240. Each of the magnets 230 is a standard post magnet, such as a rare-earth magnet, and is attached to the pole plates 210, 220 using known fastening techniques. Alternately, the magnets 230 can be fixed to the pole plates 210, 220 using magnetic forces.

A magnetic field 290 is generated by the magnet array 200, and intersects an exterior surface 282 of a post cathode cylinder 280 at an intersection point 292. The magnetic field 290 is tangential to the exterior surface 282 of the post cathode cylinder 280 at the intersection point 292. The tangential nature of the magnetic field 290/cathode cylinder 280 intersection point 292 causes the strongest effect of the magnetic field to be concentrated at the intersection point 292. This, in turn, forces cathodic arcing to occur at or near the intersection point 292. While Figure 3 illustrates the post cathode cylinder 280 on only a single side of the magnetic array 200, it is understood that the post cathode cylinder 280 would surround the magnetic array 200.

Each magnet 230 in the magnet array 240 is aligned with each other magnet 230, such that each magnet's north pole contacts a first pole plate 210, and each magnets south pole contacts a second pole plate 220. The pole plates 210, 220 are constructed of a ferro-reactive material, such as iron (Fe), and the magnets 230 are permanent magnets, such as neodymium (Nb-Fe-B) magnets. The ferro-reactivity of the pole plates 210, 220 as well as the North-South alignment of the magnet's 230 poles causes a uniform magnetic field 290 to emanate from the pole plates 210, 220 in the same manner that a magnetic field would emanate from a single solid puck-shaped magnet of the same general dimensions as the magnet array 200. The uniform magnetic field 290 provides a stronger tangential field presence at the intersection 292 with the outside surface 282 of the post cathode 280 than is provided by multiple magnets without a pole plate configuration. Each of the magnets 230 is a standard production magnet.

Turning now to Figure 4, an example magnet array 300 is illustrated with a top view. The top pole plate is omitted for illustration purposes. As shown in Figure 4, the pole plate 310 includes a center hole 312 for connecting the array 300 to a shaft. Each of the magnets 320 is arranged about the center hole 312 such that the magnets 320 are equidistant from the center hole 312, and equidistant from two adjacent magnets 320. This configuration can accommodate any number of magnets 320 beyond two, and the number of magnets combined with the strength of each magnet dictates the strength of the generated magnetic field. Each of the magnets can be attached to the pole plate 310 using any known fastening techniques. Alternate configurations creating varied strength or shaped magnetic fields could also be used according to the above disclosure.

The above example magnet array 40 and PVD system 10 are described with regards to a cylindrical post cathode 30 (illustrated in Figure 1). It is understood, however, that any shape post cathode, such as a rectangular post or a hexagonal post, could be used in place of a cylindrical post with minor modifications to the above disclosure.

Although an example embodiment has been disclosed, a worker of ordinary skill in this art would recognize that certain modifications would come within the scope of the claims. For that reason, the following claims should be studied to determine their true scope and content.

## Claims

1. A post cathode physical vapor deposition (PVD) system comprising:
a post cathode (30; 110; 280);
a magnet array (40; 160; 200; 300) movably suspended within said post cathode (30; 110; 280);
said magnet array (40; 160; 200; 300) comprising a plurality of permanent magnets (166, 168; 230; 320) having aligned magnetic poles;
wherein said plurality of permanent magnets (166, 168; 230; 320) is sandwiched between a first pole plate (164; 210; 310) and a second pole plate (162; 220; 310), and wherein each magnet (166, 168; 230; 320) in the magnet array (40; 160; 200; 300) is aligned with each other magnet (166, 168; 230; 320) such that each magnet's north pole contacts said first pole plate (164; 210; 310) and each magnet's south pole contacts said second pole plate (220).

2. A magnet array (40; 160; 200; 300) for use within a post cathode, the magnet array comprising:
a plurality of permanent magnets (166, 168; 230; 320) having aligned magnetic poles;
a first pole plate (164; 210; 310);
a second pole plate (162; 220; 310); wherein said plurality of permanent magnets (166, 168; 230; 320) is arranged between said first and second pole plate (164, 162; 210, 220; 310); and wherein each magnet (166, 168; 230; 320) in the magnet array (40; 160; 200; 300) is aligned with each other magnet (166, 168; 230; 320) such that each magnet's north pole contacts a first pole plate (164; 210; 310) and each magnet's south pole contacts a second pole plate (220); the magnet array further comprising:
a fastening feature (174; 240) arranged to connect said pole plates (164, 162; 210, 220; 310) to a shaft (50; 150; 250).

3. The post cathode PVD system or magnet array of claim 1 or 2, wherein said plurality of magnets (166, 168; 230; 320) is arranged such that a single uniform magnetic field (290) is generated, said uniform magnetic field (290) having said first pole plate (164; 210; 310) as a magnetic north and said second pole plate as a magnetic south.

4. The post cathode PVD system or magnet array of any preceding claim, wherein said first pole plate (210) is arranged to generate a magnetic north, and said second pole plate (220) is arranged to generate a magnetic south.

5. The post cathode PVD system or magnet array of any preceding claim, wherein each of said magnets (166, 168; 230; 320) in said magnet array (40; 160; 200; 300) is arranged such that said magnet array (40; 160; 200; 300) generates a single uniform magnetic field (290).

6. The post cathode PVD system or magnet array of any preceding claim, wherein said magnet array (40; 160; 200; 300) comprises at least three magnets (166, 168; 230; 320) arranged such that each magnet (166, 168; 230; 320) is equidistant from a center point (252; 312) and each of said magnets (166, 168; 230; 320) is equidistant from two adjacent magnets (166, 168; 230; 320).

7. The post cathode PVD system of any of claims 1 or 4 to 6, wherein a magnetic field (290) generated by said magnet array (40; 160; 200; 300) intersects an exterior surface (282) of said post cathode (30; 110; 280).

8. The post cathode PVD system of claim 7, wherein at a point (292) of said intersection, said exterior surface (282) of said post cathode is tangential to said magnetic field (290).

9. The post cathode PVD system or magnet array of any preceding claim, wherein said magnet array (40; 160; 200; 300) comprises five magnets (166, 168; 230; 320).

10. The post cathode PVD system or magnet array of any preceding claim, wherein each of said pole plates (164, 162; 210, 220; 310) comprises a ferro-reactive material.

11. The post cathode PVD system or magnet array of any preceding claim, wherein each of said pole plates (164, 162; 210, 220; 310) comprises iron.

12. The post cathode PVD system or magnet array of any preceding claim, wherein each of said plurality of magnets (166, 168; 230; 320) comprises a permanent magnet.

13. The post cathode PVD system or magnet array of any preceding claim, wherein each of said magnets (166, 168; 230; 320) comprises a rare earth magnet.

14. The post cathode PVD system or magnet array of claim 13, wherein each of said magnets (166, 168; 230; 320) comprises a neodymium magnet.

## Patentansprüche

1. Physisches Dampfabscheidungs(PVD)-System mit einer Rohrkathode, umfassend:
eine Rohrkathode (30; 110; 280);
eine Magnetanordnung (40; 160; 200; 300), die beweglich innerhalb der Rohrkathode (30; 110; 280) herabhängt;
wobei die Magnetanordnung (40; 160; 200; 300) eine Vielzahl von Permanentmagneten (166, 168; 230; 320) mit ausgerichteten Magnetpolen umfasst;
wobei die Vielzahl von Permanentmagneten (166, 168; 230; 320) zwischen einer ersten Polplatte (164; 210; 310) und einer zweiten Polplatte (162; 220; 310) eingelegt ist, und
wobei jeder Magnet (166, 168; 230; 320) in der Magnetanordnung (40; 160; 200; 300) mit jedem anderen Magnet (166, 168; 230; 320) derart ausgerichtet ist, dass der Nordpol jedes Magnets die erste Polplatte (164; 210; 310) berührt und der Südpol jedes Magnets die zweite Polplatte (220) berührt.

2. Magnetanordnung (40; 160; 200; 300) zur Anwendung in einer Rohrkathode, wobei die Magnetanordnung Folgendes umfasst:
eine Vielzahl von Permanentmagneten (166, 168; 230; 320) mit ausgerichteten Magnetpolen;
eine erste Polplatte (164; 210; 310);
eine zweite Polplatte (162; 220; 310);
wobei die Vielzahl von Permanentmagneten (166, 168; 230; 320) zwischen der ersten und zweiten Polplatte (164, 162; 210, 220; 310) angeordnet ist; und
wobei jeder Magnet (166, 168; 230; 320) in der Magnetanordnung (40; 160; 200; 300) mit jedem anderen Magnet (166, 168; 230; 320) derart ausgerichtet ist, dass der Nordpol jedes Magnets eine erste Polplatte (164; 210; 310) berührt und der Südpol jedes Magnets eine zweite Polplatte (220) berührt;
wobei die Magnetanordnung ferner Folgendes umfasst:
ein Befestigungsmerkmal (174; 240), das angeordnet ist, um die Polplatten (164, 162; 210, 220; 310) mit einer Welle (50; 150; 250) zu verbinden.

3. PVD-System mit Rohrkathode oder Magnetanordnung nach Anspruch 1 oder 2, wobei die Vielzahl von Magneten (166, 168; 230; 320) derart angeordnet ist, dass ein einzelnes gleichförmiges Magnetfeld (290) generiert wird, wobei das gleichförmige Magnetfeld (290) die erste Polplatte (164; 210; 310) als magnetischen Norden und die zweite Polplatte als magnetischen Süden aufweist.

4. PVD-System mit Rohrkathode oder Magnetanordnung nach einem der vorstehenden Ansprüche, wobei die erste Polplatte (210) angeordnet ist, um einen magnetischen Norden zu generieren, und die zweite Polplatte (220) angeordnet ist, einen magnetischen Süden zu generieren.

5. PVD-System mit Rohrkathode oder Magnetanordnung nach einem der vorstehenden Ansprüche, wobei jeder der Magnete (166, 168; 230; 320) in der Magnetanordnung (40; 160; 200; 300) derart angeordnet ist, dass die Magnetanordnung (40; 160; 200; 300) ein einzelnes gleichförmiges Magnetfeld (290) generiert.

6. PVD-System mit Rohrkathode oder Magnetanordnung nach einem der vorstehenden Ansprüche, wobei die Magnetanordnung (40; 160; 200; 300) mindestens drei Magnete (166, 168; 230; 320) umfasst, die derart angeordnet sind, dass jeder Magnet (166, 168; 230; 320) gleichweit von einem Mittelpunkt (252; 312) beabstandet ist und jeder der Magnete (166, 168; 230; 320) gleichweit von zwei benachbarten Magneten (166, 168; 230; 320) beabstandet ist.

7. PVD-System mit Rohrkathode nach einem der Ansprüche 1 oder 4 bis 6, wobei ein durch die Magnetanordnung (40; 160; 200; 300) generiertes Magnetfeld (290) eine Außenfläche (282) der Rohrkathode (30; 110; 280) schneidet.

8. PVD-System mit Rohrkathode nach Anspruch 7, wobei die Außenfläche (282) der Rohrkathode an einem Punkt (292) der Schnittstelle tangential zu dem Magnetfeld (290) ist.

9. PVD-System mit Rohrkathode oder Magnetanordnung nach einem der vorstehenden Ansprüche, wobei die Magnetanordnung (40; 160; 200; 300) fünf Magnete (166, 168; 230; 320) umfasst.

10. PVD-System mit Rohrkathode oder Magnetanordnung nach einem der vorstehenden Ansprüche, wobei jede der Polplatten (164, 162; 210, 220; 310) ein ferroreaktives Material umfasst.

11. PVD-System mit Rohrkathode oder Magnetanordnung nach einem der vorstehenden Ansprüche, wobei jede der Polplatten (164, 162; 210, 220; 310) Eisen umfasst.

12. PVD-System mit Rohrkathode oder Magnetanordnung nach einem der vorstehenden Ansprüche, wobei jeder der Vielzahl von Magneten (166, 168; 230; 320) einen Permanentmagnet umfasst.

13. PVD-System mit Rohrkathode oder Magnetanordnung nach einem der vorstehenden Ansprüche, wobei jeder der Magnete (166, 168; 230; 320) einen Seltene-Erden-Magnet umfasst.

14. PVD-System mit Rohrkathode oder Magnetanordnung nach Anspruch 13, wobei jeder der Magnete (166, 168; 230; 320) einen Neodymmagnet umfasst.

## Revendications

1. Système de dépôt physique en phase vapeur post-cathodique (PVD) comprenant :
une post-cathode (30 ; 110 ; 280) ;
un réseau d'aimants (40 ; 160 ; 200 ; 300) suspendu de manière mobile à l'intérieur de ladite post-cathode (30 ; 110 ; 280) ;
ledit réseau d'aimants (40 ; 160 ; 200 ; 300) comprenant une pluralité d'aimants permanents (166, 168 ; 230 ; 320) ayant des pôles magnétiques alignés ;
dans lequel ladite pluralité d'aimants permanents (166, 168 ; 230 ; 320) est prise en sandwich entre une première plaque de pôle (164 ; 210 ; 310) et une seconde plaque de pôle (162 ; 220 ; 310), et dans lequel chaque aimant (166 ; 168 ; 230 ; 320) dans le réseau d'aimants (40 ; 160 ; 200 ; 300) est aligné avec chaque autre aimant (166, 168 ; 230 ; 320) de sorte que le pôle nord de chaque aimant est en contact avec ladite première plaque de pôle (164 ; 210 ; 310) et que le pôle sud de chaque aimant est en contact avec ladite seconde plaque de pôle (220).

2. Réseau d'aimants (40 ; 160 ; 200 ; 300) destiné à être utilisé dans une post-cathode, le réseau d'aimants comprenant :
une pluralité d'aimants permanents (166, 168 ; 230 ; 320) ayant des pôles magnétiques alignés,
une première plaque de pôle (164 ; 210 ; 310) ;
une seconde plaque de pôle (162 ; 220 ; 310) ;
dans lequel ladite pluralité d'aimants permanents (166, 168 ; 230 ; 320) est agencée entre lesdites première et seconde plaques de pôle (164, 162 ; 210, 220 ; 310) ; et dans lequel chaque aimant (166 ; 168 ; 230 ; 320) dans le réseau d'aimants (40 ; 160 ; 200 ; 300) est aligné avec chaque autre aimant (166, 168 ; 230 ; 320) de sorte que le pôle nord de chaque aimant est en contact avec ladite première plaque de pôle (164 ; 210 ; 310) et que le pôle sud de chaque aimant est en contact avec une seconde plaque de pôle (220) ; le réseau d'aimants comprenant en outre :
une fonction de fixation (174 ; 240) agencée pour relier lesdites plaques de pôle (164 ; 162 ; 210, 220 ; 310) à un arbre (50 ; 150 ; 250).

3. Système PVD post-cathodique ou réseau d'aimants selon la revendication 1 ou 2, dans lequel ladite pluralité d'aimants (166, 168 ; 230 ; 320) est agencée de sorte qu'un champ magnétique uniforme unique (290) est généré, ledit champ magnétique uniforme (290) ayant ladite première plaque de pôle (164 ; 210 ; 310) en tant que nord magnétique et ladite seconde plaque de pôle en tant que sud magnétique.

4. Système PVD post-cathodique ou réseau d'aimants selon une quelconque revendication précédente, dans lequel ladite première plaque de pôle (210) est agencée pour générer un nord magnétique, et ladite seconde plaque de pôle (220) est agencée pour générer un sud magnétique.

5. Système PVD post-cathodique ou réseau d'aimants selon une quelconque revendication précédente, dans lequel chacun desdits aimants (166, 168 ; 230 ; 320) dans ledit réseau d'aimants (40 ; 160 ; 200 ; 300) est agencé de sorte que ledit réseau d'aimants (40 ; 160 ; 200 ; 300) génère un champ magnétique uniforme unique (290) .

6. Système PVD post-cathodique ou réseau d'aimants selon une quelconque revendication précédente, dans lequel ledit réseau d'aimants (40 ; 160 ; 200 ; 300) comprend au moins trois aimants (166, 168 ; 230 ; 320) agencés de sorte que chaque aimant (166, 168 ; 230 ; 320) est équidistant d'un point central (252 ; 312) et chacun desdits aimants (166, 168 ; 230 ; 320) est équidistant de deux autres aimants adjacents (166, 168 ; 230 ; 320).

7. Système PVD post-cathodique selon l'une quelconque des revendications 1 ou 4 à 6, dans lequel un champ magnétique (290) généré par ledit réseau d' aimants (40 ; 160 ; 200 ; 300) coupe une surface extérieure (282) de ladite post-cathode (30 ; 110 ; 280) .

8. Système PVD post-cathodique selon la revendication 7, dans lequel, au niveau d'un point (292) de ladite intersection, ladite surface extérieure (282) de ladite post-cathode s'étend de manière tangentielle audit champ magnétique (290).

9. Système PVD post-cathodique ou réseau d'aimants selon une quelconque revendication précédente, dans lequel chaque réseau d'aimants (40 ; 160 ; 200 ; 300) comprend cinq aimants (166 ; 168 ; 230 ; 320).

10. Système PVD post-cathodique ou réseau d'aimants selon une quelconque revendication précédente, dans lequel chacune desdites plaques de pôle (164, 162 ; 210, 220 ; 310) comprend un matériau ferro-réactif.

11. Système PVD post-cathodique ou réseau d'aimants selon une quelconque revendication précédente, dans lequel chacune desdites plaques de pôle (164, 162 ; 210, 220 ; 310) comprend du fer.

12. Système PVD post-cathodique ou réseau d'aimants selon une quelconque revendication précédente, dans lequel chacun de ladite pluralité d'aimants (166, 168 ; 230 ; 320) comprend un aimant permanent.

13. Système PVD post-cathodique ou réseau d'aimants selon une quelconque revendication précédente, dans lequel chacun desdits aimants (166, 168 ; 230 ; 320) comprend un aimant aux terres rares.

14. Système PVD post-cathodique ou réseau d'aimants selon la revendication 13, dans lequel chacun desdits aimants (166, 168 ; 230 ; 320) comprend un aimant au néodyme.
